(19) Europäisches Patentamt
European Patent Office
Office européen des brevets

(11) **EP 4 769 883 A1**

(12) **EUROPEAN PATENT APPLICATION**
published in accordance with Art. 153(4) EPC

(43) Date of publication:
**01.07.2026 Bulletin 2026/27**

(51) International Patent Classification (IPC):
*H02J 7/00* (2026.01)          *G01R 31/3835* (2019.01)
*G01R 31/392* (2019.01)          *G01R 31/396* (2019.01)

(21) Application number: 25845081.6

(22) Date of filing: 16.07.2025

(52) Cooperative Patent Classification (CPC):
G01R 31/3835; G01R 31/392; G01R 31/396;
H02J 7/00

(86) International application number:
**PCT/KR2025/010433**

(87) International publication number:
**WO 2026/023985 (29.01.2026 Gazette 2026/05)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **22.07.2024 KR 20240096201**

(71) Applicant: **LG Energy Solution, Ltd.
Seoul 07335 (KR)**

(72) Inventor: **SHIN, Jonghyuk
Daejeon 34122 (KR)**

(74) Representative: **Goddar, Heinz J.
Boehmert & Boehmert
Anwaltspartnerschaft mbB
Pettenkoferstrasse 22
80336 München (DE)**

(54) **BATTERY CHARGING CONTROL DEVICE AND METHOD, AND BATTERY SYSTEM INCLUDING SAME**

(57)     In a battery charging control device and method, and a battery system including same according to an embodiment of the present invention, a charging state of a battery being charged is monitored, a charging state change of the battery during the charging is compared with a pre-stored reference charging state change acquired from an initial-state battery, and a charging amount of the battery being charged is adjusted, so that overcharging of the battery due to degradation can be prevented.

[Figure 4]

**Description**

[Technical Field]

This application claims priority to and the benefit of Korean Patent Application No.10-2024-0096201 filed in the Korean Intellectual Property Office on July 22, 2024 the entire contents of which are incorporated herein by reference.

The present invention relates to an apparatus and method for controlling charging of a battery, and a battery system including the same, and more particularly, to a battery charging control apparatus and method, and a battery system including the same, which adjusts the charge amount in fast (or rapid) charging of a battery, based on a change in the charge state of the battery according to battery's degradation level.

[Background Art]

With the depletion of fossil fuels leading to rising energy prices and growing concerns about environmental pollution, demand for secondary batteries as an eco-friendly alternative energy source is rapidly increasing.

Because these secondary batteries can be repeatedly charged and regenerated, they are being used in a variety of applications, from small devices like mobile phones and laptops to large-scale industrial applications such as automobiles, robots, and energy storage devices, as a response to environmental regulations and high oil prices.

Among secondary batteries, lithium secondary batteries are attracting attention due to their advantages over nickel-based secondary batteries, such as minimal memory effect, low self-discharge rate, and high energy density.

Concurrently, with the increasing frequency of lithium battery use, fast charging technologies have been introduced to enable rapid battery charging.

Among conventional fast charging technologies, a method of fast charging by utilizing a rapid charging map, from which obtains a size of charging current required for rapid charging based on the temperature and state of charge (SOC) of the battery to be charged, is used.

However, conventional rapid charging maps do not consider the condition of a battery being charged, which can lead to fires caused by overcharging in deteriorated batteries or abnormalities caused by internal deterioration.

[Detailed Description of the Invention]

[Technical Problem]

To obviate one or more problems of the related art, embodiments of the present disclosure provide a battery charging control apparatus.

To obviate one or more problems of the related art, embodiments of the present disclosure also provide a battery charging control method.

To obviate one or more problems of the related art, embodiments of the present disclosure also provide a battery charging system.

[Technical Solution]

In order to achieve the objective of the present disclosure, a battery charging control apparatus, for controlling the charging of a battery, may include at least one processor; and a memory configured to store at least one instruction executed by the at least one processor, wherein the at least one instruction may include an instruction to monitor charge state of the battery undergoing charging; and an instruction to adjust a charge amount of the battery undergoing charging by comparing a change in the charge state of the battery during a process of charging with a reference charge state change which is derived from an initial state battery and pre-stored.

Here, the instruction to adjust the charge amount of the battery may include an instruction to acquire a charge state graph including at least one of a charge state of the battery in a first charge section before a charge mode of the battery is switched and a charge state of the battery in a second charge section after the switch of chage mode; an instruction to compare the charge state graph with a pre-stored reference charge state graph of the battery in its initial state to calculate a state change rate; and an instruction to adjust the charge amount of the battery based on the state change rate.

Here, the instruction to acquire the charge state graph may include an instruction to acquire a voltage pattern graph based on voltage values of the battery measured in at least one of the first charge section and the second charge section.

Furthermore, the instruction to calculate the state change rate may include an instruction to calculate the state change rate based on a degree of inflection on the voltage pattern graph, wherein the inflection occurs as the charge mode of the battery is switched.

According to embodiments, the instruction to calculate the state change rate may include an instruction to derive an inflection angle, which is an angle at a point where an inflection occurs in the voltage pattern graph; and an instruction to calculate a state change rate between the inflection angle and a pre-stored reference inflection angle of the battery in its initial state.

Here, the reference inflection angle may include a value obtained by calculating a voltage pattern graph for a battery in its initial state and measuring the inflection angle at a point where an inflection occurs in the voltage pattern graph of the battery in its initial state.

Here, the instruction to calculate a state change rate between the inflection angle and a pre-stored reference inflection angle of the battery in its initial state may include an instruction to calculate a ratio of the inflection angle to the reference inflection angle; and an instruction to calculate the state change rate from the ratio using a predefined function.

Here, the predefined function may include a hyperbolic tangent function.

Meanwhile, the first charge section may be a section where charging is performed in a constant current (CC) charge mode, and the second charge section is a section where charging is performed in a constant voltage (CV) charge mode.

Furthermore, the instruction to adjust the charge amount of the battery based on the state change rate may include an instruction to increase a charge current threshold value of the battery being charged in the second charge section based on the state change rate, thereby reducing the charge amount of the battery.

Here, the charge current threshold value may include a value that determines a charging termination time of the battery in the second charge section.

In addition, the instruction to adjust the charge amount of the battery based on the state change rate may further include an instruction to decrease a charge voltage upper limit value of the battery in the next charge cycle based on the state change rate, thereby reducing the charge amount of the battery in the next charge cycle.

According to another embodiment of the present disclosure, a battery charging control method, for controlling the charging of a battery, may include monitoring the charge state of the battery during charging; and adjusting a charge amount of the battery during charging by comparing a change in the charge state of the battery during the charging with a reference charge state change which is derived from an initial state battery and pre-stored.

Here, the adjusting of the charge amount of the battery may include acquiring a charge state graph including at least one of a charge state of the battery in a first charge section before a charge mode of the battery is switched and a charge state of the battery in a second charge section after the switch of chage mode; comparing the charge state graph with a pre-stored reference charge state graph of the battery in its initial state to calculate a state change rate; and adjusting the charge amount of the battery based on the state change rate.

Here, the acquiring of the charge state graph may include acquiring a voltage pattern graph based on voltage values of the battery measured in at least one of the first charge section and the second charge section.

Furthermore, the calculating of the state change rate may include calculating the state change rate based on a degree of inflection on the voltage pattern graph, wherein the inflection occurs as the charge mode of the battery is switched.

According to embodiments, the calculating of the state change rate may include deriving an inflection angle, which is an angle at a point where an inflection occurs in the voltage pattern graph; and calculating a state change rate between the inflection angle and a pre-stored reference inflection angle of the battery in its initial state.

Here, the reference inflection angle may include a value obtained by calculating a voltage pattern graph for a battery in its initial state and measuring the inflection angle at a point where an inflection occurs in the voltage pattern graph of the battery in its initial state.

Here, the calculating of the state change rate between the inflection angle and a pre-stored reference inflection angle of the battery in its initial state may include calculating a ratio of the inflection angle to the reference inflection angle; and calculating the state change rate from the ratio using a predefined function.

Here, the predefined function may include a hyperbolic tangent function.

Meanwhile, the first charge section may be a section where charging is performed in a constant current (CC) charge mode, and the second charge section is a section where charging is performed in a constant voltage (CV) charge mode.

Furthermore, the adjusting of the charge amount of the battery based on the state change rate may include increasing a charge current threshold value of the battery being charged in the second charge section based on the state change rate, thereby reducing the charge amount of the battery.

Here, the charge current threshold value includes a value that determines a charging termination time of the battery in the second charge section.

In addition, the adjusting of the charge amount of the battery based on the state change rate further may include decreasing a charge voltage upper limit value of the battery in the next charge cycle based on the state change rate, thereby reducing the charge amount of the battery in the next charge cycle.

According to another embodiment of the present disclosure, a battery charging system for controlling the charging of a battery may include a battery; a charging device configured to charge the battery by applying a charging current to the battery; and a battery charging control apparatus configured to control a magnitude of the charging current provided by the charging device, wherein the battery charging control apparatus monitors charge state of the battery undergoing charging and adjusts a charge amount of the battery undergoing charging by comparing a change in the charge state of the battery during a process of charging with a reference charge state change which is derived from an initial state battery and pre-stored.

[Advantageous Effects]

A battery charging control apparatus and method, and a battery system including the same according to embodiments of the present invention, calculates a state change rate according to a deterioration degree of a battery being charged, reflects the state change rate during a charging process, and thus, prevents overcharging of the battery caused by lithium precipitation, thereby enabling rapid charging with high stability.

[Brief Description of the Drawings]

FIG. 1 is a block diagram of a battery system to which embodiments of the present invention can be applied.

FIG. 2 is a block diagram of a battery charging system according to embodiments of the present invention.

FIG. 3 is a block diagram of a battery charging control apparatus in a battery charging system according to embodiments of the present invention.

FIG. 4 is a flowchart illustrating a battery charging control method performed by a processor within a battery charging control apparatus according to embodiments of the present invention.

FIG. 5 is a flowchart illustrating a step of monitoring the charge state of a battery in a battery charging control method according to embodiments of the present invention.

FIG. 6 is a graph of battery voltage and current according to a charge mode in a battery charging control method according to embodiments of the present invention.

FIG. 7 is a graph of battery voltage for determining a charging current upper limit in a battery charging control method according to embodiments of the present invention.

FIG. 8 is a flowchart illustrating a method for adjusting the charge amount of a battery in the battery charging control method according to embodiments of the present invention.

FIG. 9 is a graph illustrating a method for calculating a state change rate in a battery charging control method according to embodiments of the present invention.

FIG. 10 is a flowchart illustrating a method for adjusting a charge amount in a battery charging control method according to an embodiment of the present invention.

FIG. 11 is a flowchart illustrating a method for adjusting the charge amount in a battery charging control method according to another embodiment of the present invention.

100: battery 300: charging device
500: battery charging control apparatus
510: memory 520: processor
530: transceiver 540: input interface
550: output interface 560: storage device
570: bus

[Best Modes for Practicing the Disclosure]

The present invention may be modified in various forms and have various embodiments, and specific embodiments thereof are shown by way of example in the drawings and will be described in detail below. It should be understood, however, that there is no intent to limit the present invention to the specific embodiments, but on the contrary, the present invention is to cover all modifications, equivalents, and alternatives falling within the spirit and technical scope of the present invention. Like reference numerals refer to like elements throughout the description of the figures.

It will be understood that, although the terms such as first, second, A, B, and the like may be used herein to describe various elements, these elements should not be limited by these terms. These terms are only used to distinguish one element from another. For example, a first element could be termed a second element, and, similarly, a second element could be termed a first element, without departing from the scope of the present invention. As used herein, the term "and/or" includes combinations of a plurality of associated listed items or any of the plurality of associated listed items.

It will be understood that when an element is referred to as being "coupled" or "connected" to another element, it can be directly coupled or connected to the other element or an intervening element may be present. In contrast, when an element is referred to as being "directly coupled" or "directly connected" to another element, there is no intervening element present.

The terms used herein is for the purpose of describing specific embodiments only and are not intended to limit the present invention. As used herein, the singular forms "a", "an" and "the" are intended to include the plural forms as well, unless the context clearly indicates otherwise. It will be further understood that the terms "comprises", "comprising", "includes", "including" and/or "having", when used herein, specify the presence of stated features, integers, steps, operations, constitutional elements, components and/or combinations thereof, but do not preclude the presence or addition of one or more other features, integers, steps, operations, constitutional elements, components, and/or combinations thereof.

Unless otherwise defined, all terms used herein, including technical and scientific terms, have the same meanings as commonly understood by one skilled in the art to which the present invention belongs. It will be further understood that terms, such as those defined in commonly used dictionaries, should be interpreted as having meanings that are consistent with their meanings in the context of the relevant art and will not be interpreted in an idealized or overly formal sense unless expressly so defined herein.

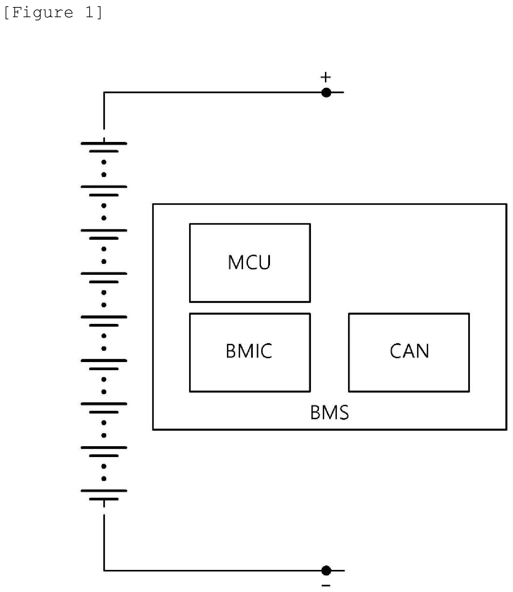

FIG. 1 is a block diagram of a battery system to which embodiments of the present invention can be applied.

Referring to FIG. 1, a battery may include a plurality of battery cells connected in series or modules. The battery cells or modules may be connected to a load through their positive and negative terminals, enabling battery cells or modules to perform charging and discharging operations. The most commonly used battery cells are lithium-ion (Li-Ion) battery cells.

The battery cells or battery modules may be connected to and interwork with a battery management system (BMS).

The battery management system may monitor a current, a voltage and a temperature of each battery cell or module to be managed, calculate state of charge (SOC) of the battery based on monitoring results to control charging and discharging. Here, the state of charge (SOC) refers to a current state of charge of a battery, represented in percent points [%], and the State of Health (SOH) may be a current deteriorated condition of a battery compared to its ideal conditions, represented in percent points [%].

As described, the battery management system (BMS) may monitor battery cells, read their individual voltage values, and transmit their individual voltage values to other systems connected to the battery.

Furthermore, the battery management system may monitor at least one electrical component constituting the battery system and passes their state data on to other systems. For this, the BMS may include a communication module for communicating with other systems in a device including the battery system.

The communication module of the BMS may communicate with other systems in the device using Controller Area Network (CAN). Here, components, modules or systems in the BMS are connected to each other through a CAN bus. Accordingly, the battery management system (BMS) may use CAN communication to remotely transmit status data obtained through monitoring of the battery pack or module and at least one electrical component constituting the battery management system (BMS) to other systems.

Meanwhile, the battery management system (BMS) may equally balance charges of the battery cells in order to extend the life of the battery system.

The battery management system (BMS) may include various components such as a fuse, a current sensing element, a thermistor, a switch, and a balancer to perform such operations. In most cases, a micro controller unit (MCU) or a battery monitoring integrated chip (BMIC) for interworking and controlling these components is additionally included in the BMS.

Meanwhile, a battery charging system according to embodiments of the present invention may be provided as a component within a battery management system (BMS) and control battery charging.

Hereinafter, a preferred embodiment of a battery charging system according to embodiments of the present invention will be described in detail with reference to the attached drawings.

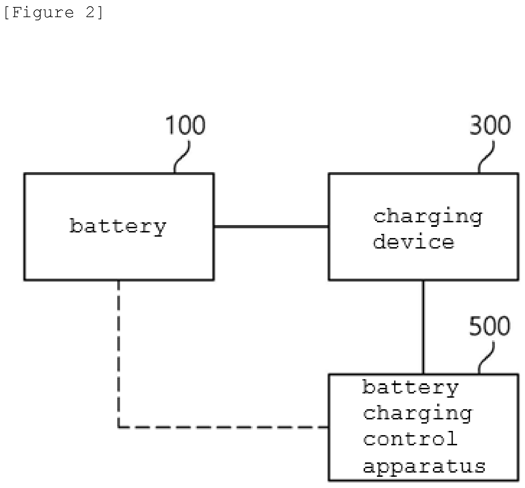

FIG. 2 is a block diagram of a battery charging system according to embodiments of the present invention.

Referring to FIG. 2, the battery charging system according to embodiments of the present invention may be a system that controls battery charging. According to embodiments, the battery charging system may control fast battery charging.

More specifically, the battery charging system may include a battery 100, a charging device 300, and a battery charging control apparatus 500.

The battery 100 may be provided as one or more battery cells. For example, if the battery 100 is provided as a plurality of battery cells, the battery cells may be provided in a structure in which they are connected in series.

The charging device 300 may be electrically connected to the battery 100 and the battery charging control apparatus 500, and charge the battery 100.

More specifically, the charging device 300 according to embodiments may receive a value of charging current to be applied to the battery 100 from the battery charging control apparatus 500. Thereafter, the charging device 300 may apply a charging current to the battery 100 based on the charging current value, thereby rapidly charging the battery 100.

The battery charging control apparatus 500 may be electrically connected to the battery 100. Accordingly, the battery charging control apparatus 500 may control charging of the battery 100.

According to embodiments, when rapid charging of the battery, the battery charging control apparatus 500 may switch a charge mode and perform charging. For example, the battery charge control apparatus 500 may perform constant current (CC)-constant voltage (CV) charging on the battery 100.

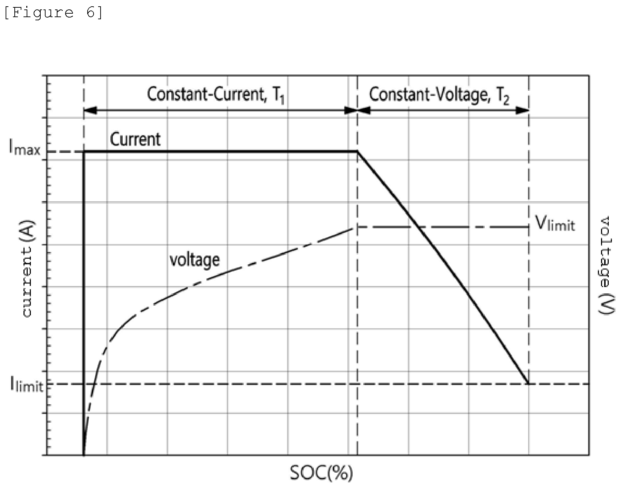

Here, the battery charge control apparatus 500 may adjust charge amount of the battery 100 by considering the degree of degradation of the battery 100 during the charging process of the battery 100. According to embodiments, the battery charge control apparatus 500 may adjust at least one charging condition for charging control of the battery 100 to adjust the charge amount based on the degree of degradation of the battery 100. For example, the charging condition may be at least one of a charging current threshold value and a charging voltage upper limit value. The charging current threshold value and the charging voltage upper limit value will be described in detail with reference to FIG. 6.

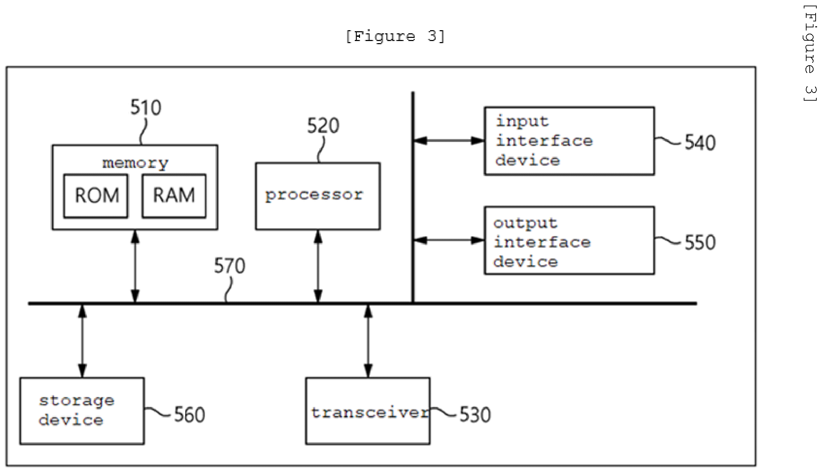

FIG. 3 is a block diagram of a battery charging control apparatus in a battery charging system according to embodiments of the present invention.

Describing in more detail component by component referring to FIG. 3, the battery charging control apparatus 500 may include a memory 510, a processor 520, a transceiver 530, an input interface device 540, an output interface device 550, and a storage device 560.

According to embodiments, respective components 510, 520, 530, 540, 550, 560 included in the battery charging control apparatus 500 may be connected via a bus 570 to communicate with each other.

Among the above components 510, 520, 530, 540, 550, and 560, the memory 510 and the storage device 560 may include at least one of a volatile/transitory storage medium and a non-volatile/non-transitory storage medium. For example, the memory may include at least one of a read-only memory (ROM) and random access memory (RAM), and may include an Electrically Erasable Programmable Read-only Memory (EEPROM).

Among these, the memory 510 may include at least one instruction executed by the processor 520.

According to embodiments, a battery charging control apparatus for controlling the charging of a battery, may include at least one processor; and a memory configured to store at least one instruction executed by the at least one processor, wherein the at least one instruction may include an instruction to monitor the charge state of the battery undergoing charging; and an instruction to adjust a charge amount of the battery undergoing charging by comparing a change in the charge state of the battery during a process of charging with a reference charge state change which is derived from an initial state battery and pre-stored.

Here, the instruction to adjust the charge amount of the battery may include an instruction to acquire a charge state graph including at least one of a charge state of the battery in a first charge section before a charge mode of the battery is switched and a charge state of the battery in a second charge section after the switch of chage mode; an instruction to compare the charge state graph with a pre-stored reference charge state graph of the battery in its initial state to calculate a state change rate; and an instruction to adjust the charge amount of the battery based on the state change rate.

Here, the instruction to acquire the charge state graph may include an instruction to acquire a voltage pattern graph based on voltage values of the battery measured in at least one of the first charge section and the second charge section.

Furthermore, the instruction to calculate the state change rate may include an instruction to calculate the state change rate based on a degree of inflection on the voltage pattern graph, wherein the inflection occurs as the charge mode of the battery is switched.

According to embodiments, the instruction to calculate the state change rate may include an instruction to derive an inflection angle, which is an angle at a point where an inflection occurs in the voltage pattern graph; and an instruction to calculate a state change rate between the inflection angle and a pre-stored reference inflection angle of the battery in its initial state.

Here, the reference inflection angle may include a value obtained by calculating a voltage pattern graph for a battery in its initial state and measuring the inflection angle at a point where an inflection occurs in the voltage pattern graph of the battery in its initial state.

Here, the instruction to calculate a state change rate between the inflection angle and a pre-stored reference inflection angle of the battery in its initial state may include an instruction to calculate a ratio of the inflection angle to the reference inflection angle; and an instruction to calculate the state change rate using the ratio and a predefined function.

Here, the predefined function may include a hyperbolic tangent function.

Meanwhile, the first charge section is a section where charging is performed in a constant current (CC) charge mode, and the second charge section is a section where charging is performed in a constant voltage (CV) charge mode.

Furthermore, the instruction to adjust the charge amount of the battery based on the state change rate may include an instruction to increase a charge current threshold value of the battery being charged in the second charge section based on the state change rate, thereby reducing the charge amount of the battery.

Here, the charge current threshold value includes a value that determines a charging termination time of the battery in the second charge section.

In addition, the instruction to adjust the charge amount of the battery based on the state change rate may further include an instruction to decrease a charge voltage upper limit value of the battery in the next charge cycle based on the state change rate, thereby reducing the charge amount of the battery in the next charge cycle.

Meanwhile, the processor 520 may refer to a central processing unit (CPU), a graphics processing unit (GPU), or a dedicated processor that executes methods according to embodiments of the present invention.

As previously described, the processor 520 may execute at least one program command stored in the memory 510.

The battery charging system including the battery charging control apparatus according to embodiments of the present invention has been described above. A battery charging control method performed by the processor operation of the battery charging control apparatus according to embodiments of the present invention will be described in more detail below.

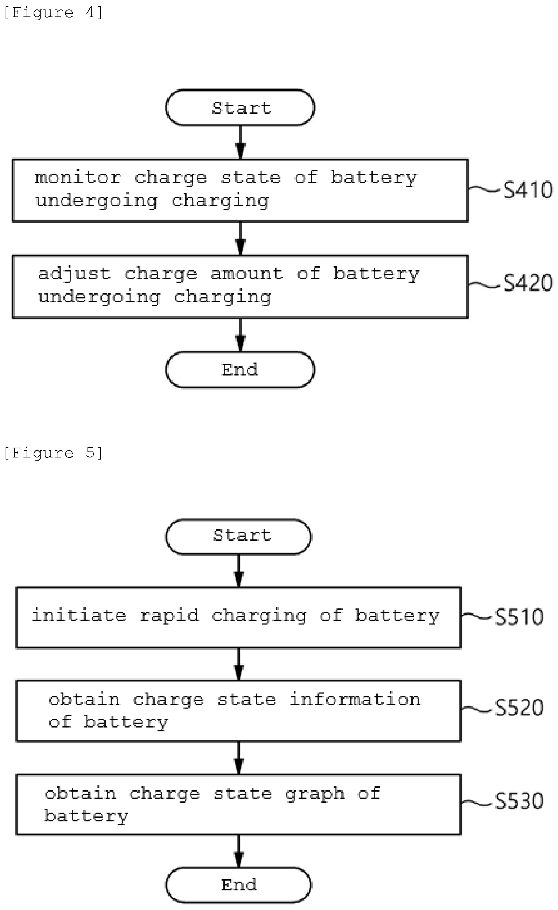

FIG. 4 is a flowchart illustrating a battery charging control method performed by a processor within a battery charging control apparatus according to embodiments of the present invention.

Referring to FIG. 4, a processor 520 in the battery charging control apparatus 500 according to embodiments of the present invention may control fast charging of a battery 100 using a charging device 300. More specifically, the processor 520 according to embodiments may transmit a predefined charging current value to a charging device 300 connected to the battery 100. Accordingly, the charging device 300 may apply a charging current with a magnitude corresponding to the received charging current value to the battery 100. Thus, the battery 100 may be charged by the charging current. According to embodiments of the present invention, the battery 100 may be rapidly charged by the charging current.

Thereafter, the processor 520 may monitor a charge state of the battery 100 undergoing rapid (or fast) charging (S410).

According to embodiments, the battery charge control apparatus 500 may obtain at least one piece of charge state information from the battery 100 undergoing rapid charging. In other words, the battery charge control apparatus 500 may monitor the charge state of the battery (S410). Here, the at least one piece of charge state information may include at least one piece of information among the state of charge (SOC), voltage (V), and current (I) of the battery 100 undergoing rapid charging. For example, the charge state information may be a voltage (V) value of the battery 100.

Thereafter, the processor 520 may adjust a charge amount of the battery 100 by comparing a change in the charge state of the battery 100 undergoing rapid charging with a reference change in the charge state which is obtained from the initial state of the battery and pre-stored (S420).

More specifically, according to embodiments, the processor 520 may monitor voltage (V) values of the battery 100 being charged in real time and generate a voltage pattern graph of the battery 100 being charged.

Thereafter, the processor 520 may compare the voltage pattern graph acquired in real time with a reference voltage pattern graph of the battery in its initial state, calculate a state change rate, and thereby analyzing the degree of battery degradation.

Thereafter, the processor 520 may adjust the charge amount of the battery 100 by considering the degree of battery degradation based on the state change rate.

FIG. 5 is a flowchart illustrating a step of monitoring the charge state of a battery in a battery charging control method according to embodiments of the present invention.

Referring to FIG. 5, the processor 520 may transmit a charge start signal and a charge current value to a charging device 300 connected to the battery 100 according to a charge mode. Accordingly, the battery 100 may receive charge current corresponding to the charge current value from the charging device 300 and initiate rapid charging in a first charge mode (S510). Here, the charge current value may include, for example, at least one of a charging current upper limit value (Imax) and a charging current threshold value (Ilimit).

Thereafter, the processor 520 may obtain charge state information of the battery 100 in real time from the battery 100 undergoing rapid charging (S520). Accordingly, the processor 520 may obtain a charge state graph based on the charge state information of the battery 100 (S530). According to embodiments, the charge state information may include a voltage (V) value of the battery 100, and the charge state graph may be a voltage pattern graph of the battery 100.

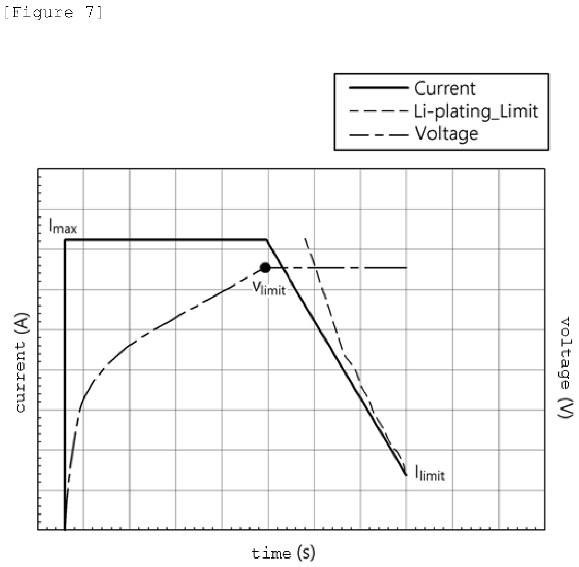

FIG. 6 is a graph of battery voltage and current according to a charge mode in a battery charging control method according to embodiments of the present invention and FIG. 7 is a graph of battery voltage for determining a charging current upper limit in a battery charging control method according to embodiments of the present invention.

Referring to FIG. 6, the processor 520 may control rapid charging of the battery 100 according to the charge mode, as illustrated in FIG. 5.

According to embodiments, the processor 520 may rapidly charge the battery 100 in a plurality of charge modes. More specifically, the processor 520 may rapidly charge the battery 100 in a first charge mode during a first charge section (T1), and then switch the charge mode in a second charge section (T2) to rapidly charge the battery 100 in a second charge mode. For example, the processor 520 may rapidly charge the battery 100 in a constant current (CC)-constant voltage (CV) charge mode.

In more detail, the processor 520 may transmit a charging start signal and a charging current upper limit value (Imax) to the charging device 300. Accordingly, the battery 100 may receive a charging current corresponding to the charging current upper limit value (Imax) from the charging device 300 and start charging in the constant current (CC) charge mode, which is the first charge mode. Here, the charging current upper limit value (Imax) may be determined to an upper limit value of the charging current corresponding to the maximum output current that can be output by the charging device 300 or corresponding to the state of charge (SOC) of the battery, which is predefined in a rapid charging map.

Thereafter, the processor 520 may monitor charging voltage values from the battery 100 in real time while constant current (CC) charging according to the first charge mode is in progress. Accordingly, the processor 520 may linearize the charging voltage values monitored in real time in the first charge section (T1) to obtain a first voltage pattern graph. For example, the first voltage pattern graph may be an upward-sloping graph.

Here, when the voltage of the battery 100 reaches a predefined charging voltage upper limit value (Vmax), the processor 520 may switch the charge mode of the battery 100 from the first charge mode to the second charge mode. Here, the predefined charging voltage upper limit value (Vmax) may be a value predefined based on a previously performed lithium plating experiment on the battery (see FIG. 7). In other words, the charging voltage upper limit value (Vmax) may be determined to the maximum voltage value of the battery at which lithium does not deposit on the electrode surface during rapid charging.

Thereafter, the processor 520 may transmit a charging current threshold value (Ilimit) along with a charge mode switching signal to the charging device 300. Accordingly, the charging device 300 may reduce the magnitude of the charging current of the battery 100 to the charging current threshold value (Ilimit) while maintaining the charging voltage of the battery 100 at the charging voltage upper limit value (Vmax) during the second charge section (T2). Here, the charging current threshold value (Ilimit) may be a value that determines a charging termination time of the battery 100 in the second charge section (T2). In other words, when the magnitude of the charging current of the battery 100 reaches a magnitude corresponding to the charging current threshold value (Ilimit), the processor 520 may transmit a charging termination signal to the charging device 300 to terminate the charging of the battery 100 in the second charge mode.

Meanwhile, the processor 520 may monitor charging voltage values of the battery 100 in real time while constant voltage (CV) charging according to the second charge mode is in progress.

According to embodiments, the processor 520 may monitor the charging voltage values from the battery 100 in real time for a predetermined period of time starting from the point in time when the charge mode of the battery 100 switches from the first charge mode to the second charge mode. Accordingly, the processor 520 may linearize the voltage values monitored in real time in the second charge mode to obtain a second voltage pattern graph.

However, the second voltage pattern graph may be displayed in a horizontal graph form because the charging current of the charging device 300 may be adjusted by the processor 520 so that the charging voltage of the battery 100 remains within the charging voltage upper limit value (Vmax).

Accordingly, the processor 520 in the battery charging control apparatus according to the embodiment of the present invention, without being limited to what has been described, may obtain a second voltage pattern graph by horizontally extending the charging voltage upper limit value, which is the last value on the first voltage pattern graph in the first charge mode, by a predetermined length without obtaining real-time charge state information from the battery 100 in the second charge section (T2).

Thus, the processor 520 may obtain a voltage pattern graph including the first voltage pattern graph and the second voltage pattern graph.

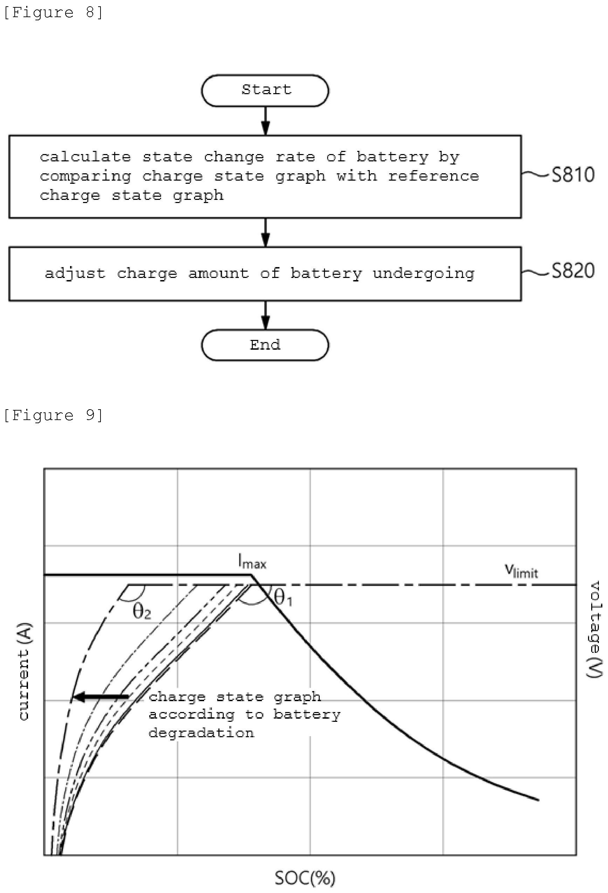

FIG. 8 is a flowchart illustrating a method for adjusting the charge amount of a battery in the battery charging control method according to embodiments of the present invention.

Referring to FIG. 8, the processor 520 may compare a charge state graph obtained through charge state monitoring of the battery 100 with a reference charge state graph of the battery in its initial state to calculate a state change rate (S810). Here, the battery in its "initial state" may refer to a battery in its normal state in which lithium plating has not occurred. In other words, the processor 520 may compare a charge state graph of a battery 100 undergoing rapid charging in a second charge mode with a charge state graph of a battery in its initial state that has not deteriorated to calculate a state change rate, thereby determining the degree of degradation of the battery 100 undergoing rapid charging.

Thereafter, the processor 520 may adjust the charge amount of the battery 100 undergoing rapid charging in the second charging section (T2) based on the state change rate (S820).

FIG. 9 is a graph illustrating a method for calculating a state change rate in a battery charging control method according to embodiments of the present invention.

Referring to FIG. 9, the processor 520 may compare the degree of inflection of the charge state graph of the battery 100 with the reference degree of inflection of the reference charge state graph of the battery in its initial state.

According to embodiments, the processor 520 may compare the inflection angle ($\theta$1) of the charge state graph of the battery 100 with the reference inflection angle ($\theta$2) of the reference charge state graph of the battery in its initial state. Here, the inflection angle may be an angle formed at a point where an inflection occurs on the charge state graph.

More specifically, the processor 520 may calculate a slope of the first charge state graph of the battery 100 in its first charge mode and a slope of the second charge state graph in its second charge mode. Thereafter, the processor 520 may derive the size of the inflection angle ($\theta$1) between the first charge state graph and the second charge state graph from the slope of the first charge state graph and the slope of the second charge state graph. However, without being limited to the disclosure, the processor 520 may derive the size the inflection angle ($\theta$1) of the battery 100 based on the slope of the first charge state graph when the second charge state graph is provided in a horizontal form.

Thereafter, the processor 520 may compare the derived inflection angle of the battery 100 with a pre-stored reference inflection angle ($\theta$2) of the battery in its initial state. According to embodiments, the processor 520 may compare the inflection angle ($\theta$1) and the reference inflection angle ($\theta$2) to calculate a ratio (x) of the inflection angle ($\theta$1) of the battery 100 to the reference inflection angle ($\theta$2). For example, the ratio (x) may be a value between greater than 0 and less than 1. In addition, the reference inflection angle ($\theta$2) may be a determined value pre-stored in the memory 510 or storage device 560, which is calculated in the same manner as the inflection angle ($\theta$1) of the battery 100.

Thereafter, the processor 520 may calculate a state change rate (R) using the ratio (x) and a predefined function. According to embodiments, the processor 520 may output the state change rate (R) using the hyperbolic tangent function of the ratio (x) as in equation 1 below.

[Equation 1]

$$R = \frac{1}{\tanh x}$$

Here, x is the ratio of the inflection angle to the reference inflection angle and R is the state change rate.

Generally, during rapid (fast) charging, a battery may degrade as lithium precipitates on the battery surface. Consequently, the battery voltage during the constant current charge section may increase rapidly compared to the initial battery voltage.

Accordingly, the battery charge control method according to embodiments of the present invention may compare the charge state between a battery in a normal state and a battery 100 undergoing rapid charging in a second charge mode. Based on this comparison, the state change rate reflecting the degree of battery degradation may be calculated and applied to the charge amount in the second charge mode, which allows rapid charging control based on the degree of battery degradation.

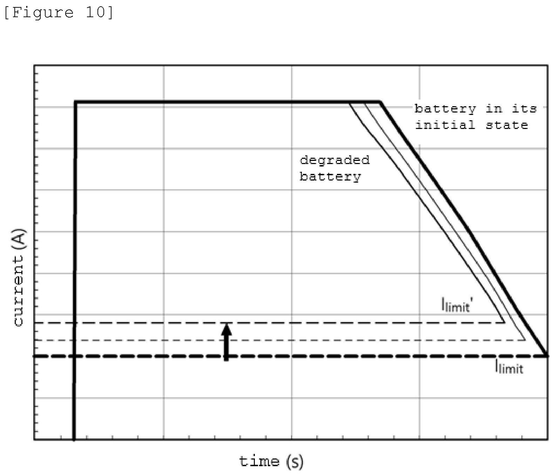

FIG. 10 is a flowchart illustrating a method for adjusting a charge amount in a battery charging control method according to an embodiment of the present invention.

Referring to FIG. 10, the processor 520 may adjust the charge amount of the battery 100 based on the calculated state change rate.

According to the embodiment, the processor 520 may adjust a charge current threshold value of the battery 100 being charged in the second charge section (T2) and thereby adjust a charging termination time point, thereby controlling the charge amount of the battery 100.

More specifically, the processor 520 may calculate a second charge current threshold value (Ilimit') by reflecting the state change rate (R) to a predetermined first charge current threshold value (Ilimit) of the battery 100 being rapidly charged in the second charge section (T2).

For example, according to one embodiment, the processor 520 may multiply a predetermined first charging current threshold value (Ilimit) by a state change rate (R) to calculate a second charging current threshold value (Ilimit').

Furthermore, according to another embodiment, the processor 520 may multiply a predetermined first charging current threshold value (Ilimit) by a preset adjustment constant which is multiplied by the state change rate (R), to calculate a second charging current threshold value (Ilimit').

Meanwhile, the state change rate (R) may be greater than 1. Accordingly, the second charging current threshold value (Ilimit') may be adjusted upward compared to the first charging current threshold value (Ilimit). Accordingly, the charging termination point of the battery 100 may be determined to an earlier time point, thereby reducing the charge amount of the battery 100.

In other words, the processor 520 may reduce the charge amount of the battery 100 by upwardly adjusting the first charge current threshold value (Ilimit) of the battery 100 being rapidly charged in the second charge section (T2) in consideration of the current degradation state of the battery 100.

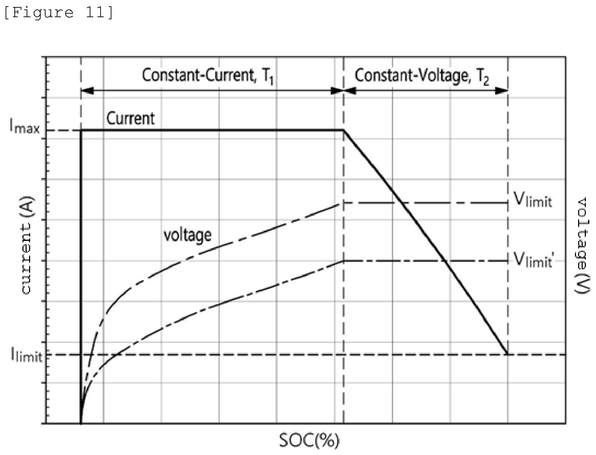

FIG. 11 is a flowchart illustrating a method for adjusting the charge amount in a battery charging control method according to another embodiment of the present invention.

Referring to FIG. 11, the processor 520 may adjust the charge amount of the battery 100 based on the calculated state change rate.

According to the embodiment, the processor 520 may adjust a charge amount of the battery 100 by adjusting a charge current threshold value of the battery 100 being charged in the second charge section (T2).

More specifically, the processor 520 may calculate the second charge current threshold value (Ilimit') by reflecting the state change rate (R) to a predetermined first charge current threshold value (Ilimit) of the battery 100 being rapidly charged in the second charge section (T2).

Here, the state change rate (R) may be greater than 1. Accordingly, the second charging current threshold value (Ilimit') may be adjusted upward compared to the first charging current threshold value (Ilimit). Therefore, the charge amount of the battery 100 may decrease.

Thereafter, the processor 520 may calculate the second charging voltage upper limit value (Vlimit') by reflecting the state change rate (R) to a predetermined first charging voltage upper limit value (Vlimit). More specifically, the processor 520 may adjust the second charging voltage upper limit value (Vlimit') downward by reflecting the state change rate (R) to the predetermined first charging voltage upper limit value (Vlimit).

For example, according to one embodiment, the processor 520 may calculate the second charging voltage upper limit value (Vlimit') by multiplying the predetermined first charging voltage upper limit value (Vlimit) by the reciprocal of the state change rate (R).

Furthermore, according to another embodiment, the processor 520 may calculate the second charging voltage upper limit value (Vlimit') by multiplying the predetermined first charging voltage upper limit value (Vlimit) by a predetermined adjustment constant which is multiplied by the inverse of the state change rate (R).

Meanwhile, the inverse of the state change rate (R) may be less than 1. Accordingly, the second charging current threshold value (Ilimit') may be adjusted upward compared to the first charging current threshold value (Ilimit).

Thereafter, the processor 520 may store the calculated second charging voltage upper limit value (Vlimit') in the memory 510 or the storage device 560. According to embodiments, the processor 520 may store the second charging voltage upper limit value (Vlimit') by updating the pre-stored first charging voltage upper limit value (Vlimit). Accordingly, the processor 520 may apply the stored second charging voltage upper limit value (Vlimit') when performing the next rapid charging cycle of the battery 100, thereby performing rapid charging according to the first and second charge modes. Here, the second charging voltage upper limit value (Vlimit') may be lower than the first charging voltage upper limit value (Vlimit). Therefore, the charge amount of the battery 100 may be reduced.

In summary, the processor 520 in the battery charging control apparatus according to one embodiment and another embodiment of the present invention may measure the deterioration state of the battery 100 each time the battery 100 is rapidly charged, and reflect the deterioration state of the battery in the charge amount of the battery in the second charge mode, thereby preventing a fire in the battery 100 due to overcharging.

The battery charging control apparatus and method according to the embodiment of the present invention, and the battery system including the same, have been described above.

A battery charging control apparatus and method, and a battery system including the same according to embodiments of the present invention, adjusts the charge amount of the battery in a second charge mode in consideration of lithium precipitation occurring as the charging of the battery progresses, thereby preventing a fire caused by overcharging when charging a degraded battery, thereby allowing the battery to be charged stably.

The operations of the method according to embodiments of the present invention may be implemented in various forms related to programs, such as a computer program or code itself, or a computer program product.

Furthermore, the computer-readable recording medium may include one or more of a volatile/transitory recording medium and a non-volatile/non-transitory recording medium.

In addition, the computer-readable recording medium may include hardware devices specially configured to store and execute program instructions, such as ROM, RAM, flash memory, and may include, for example, various types of servers located on a network. The program instructions may include not only machine language codes, such as those created by a compiler, but also high-level language codes that can be executed by a computer using an interpreter.

Although some aspects of the invention have been described in the context of the apparatus, it may also represent a description according to a corresponding method, wherein a block or apparatus corresponds to a method step or feature of a method step. Similarly, aspects described in the context of a method may also represent a feature of a corresponding block or item or a corresponding apparatus. Some or all of the method steps may be performed by (or using) a hardware device, such as, for example, a microprocessor, a programmable computer, or an electronic circuit. In some embodiments, one or more of the most important method steps may be performed by such an apparatus.

In the forgoing, the present invention has been described with reference to the exemplary embodiment of the present invention, but those skilled in the art may appreciate that the present invention may be variously corrected and changed within the range without departing from the spirit and the area of the present invention described in the appending claims.

**Claims**

1. A battery charging control apparatus for controlling the charging of a battery, the apparatus comprising:

   at least one processor; and
   a memory configured to store at least one instruction executed by the at least one processor, wherein the at least one instruction includes:

   an instruction to monitor charge state of the battery undergoing charging; and
   an instruction to adjust a charge amount of the battery undergoing charging by comparing a change in the charge state of the battery during a process of charging with a reference charge state change which is derived from an initial state battery and pre-stored.

2. The apparatus of claim 1, wherein the instruction to adjust the charge amount of the battery includes:

   an instruction to acquire a charge state graph including at least one of a charge state of the battery in a first charge section before a charge mode of the battery is switched and a charge state of the battery in a second charge section after the switch of chage mode;
   an instruction to compare the charge state graph with a pre-stored reference charge state graph of the battery in its initial state to calculate a state change rate; and
   an instruction to adjust the charge amount of the battery based on the state change rate.

3. The apparatus of claim 2, wherein the instruction to acquire the charge state graph includes:
   an instruction to acquire a voltage pattern graph based on voltage values of the battery measured in at least one of the first charge section and the second charge section.

4. The apparatus of claim 2, wherein the instruction to calculate the state change rate includes:
   an instruction to calculate the state change rate based on a degree of inflection on the voltage pattern graph, wherein the inflection occurs as the charge mode of the battery is switched.

5. The apparatus of claim 2, wherein the instruction to calculate the state change rate includes:

an instruction to derive an inflection angle, which is an angle at a point where an inflection occurs in the voltage pattern graph; and
an instruction to calculate a state change rate between the inflection angle and a pre-stored reference inflection angle of the battery in its initial state.

6. The apparatus of claim 5, wherein the reference inflection angle includes:
a value obtained by calculating a voltage pattern graph for a battery in its initial state and measuring the inflection angle at a point where an inflection occurs in the voltage pattern graph of the battery in its initial state.

7. The apparatus of claim 5, wherein the instruction to calculate the state change rate between the inflection angle and a pre-stored reference inflection angle of the battery in its initial state includes:

an instruction to calculate a ratio of the inflection angle to the reference inflection angle; and
an instruction to calculate the state change rate from the ratio using a predefined function.

8. The apparatus of claim 7, wherein the predefined function includes a hyperbolic tangent function.

9. The apparatus of claim 2, wherein the first charge section is a section where charging is performed in a constant current (CC) charge mode and the second charge section is a section where charging is performed in a constant voltage (CV) charge mode.

10. The apparatus of claim 9, wherein the instruction to adjust the charge amount of the battery based on the state change rate includes:
an instruction to increase a charge current threshold value of the battery being charged in the second charge section based on the state change rate, thereby reducing the charge amount of the battery.

11. The apparatus of claim 10, wherein the charge current threshold value includes a value that determines a charging termination time of the battery in the second charge section.

12. The apparatus of claim 10, wherein the instruction to adjust the charge amount of the battery based on the state change rate further includes:

an instruction to decrease a charge voltage upper limit value of the battery in the next charge cycle based on the state change rate, thereby reducing the charge amount of the battery in the next charge cycle.

13. A control method, performed by a battery charging control apparatus for controlling the charging of a battery, the method comprising:
monitoring charge state of the battery during charging; and
adjusting a charge amount of the battery during charging by comparing a change in the charge state of the battery during the charging with a reference charge state change which is derived from an initial state battery and pre-stored.

14. The method of claim 13, wherein the adjusting of the charge amount of the battery includes:

acquiring a charge state graph including at least one of a charge state of the battery in a first charge section before a charge mode of the battery is switched and a charge state of the battery in a second charge section after the switch of chage mode;
comparing the charge state graph with a pre-stored reference charge state graph of the battery in its initial state to calculate a state change rate; and
adjusting the charge amount of the battery based on the state change rate.

15. The method of claim 14, wherein the acquiring of the charge state graph includes:
acquiring a voltage pattern graph based on voltage values of the battery measured in at least one of the first charge section and the second charge section.

16. The method of claim 14, wherein the calculating of the state change rate includes:
calculating the state change rate based on a degree of inflection on the voltage pattern graph, wherein the inflection occurs as the charge mode of the battery is switched.

17. The method of claim 14, wherein the calculating of the state change rate includes:

deriving an inflection angle, which is an angle at a point where an inflection occurs in the voltage pattern graph; and
calculating a state change rate between the inflection angle and a pre-stored reference inflection angle of the battery in its initial state.

18. The method of claim 17, wherein the reference inflection angle includes:

a value obtained by calculating a voltage pattern graph for a battery in its initial state and measuring the inflection angle at a point where an inflection occurs in the voltage pattern graph of the battery in its initial state.

19. The method of claim 17, wherein the calculating of the state change rate between the inflection angle and a pre-stored reference inflection angle of the battery in its initial state includes:

calculating a ratio of the inflection angle to the reference inflection angle; and
calculating the state change rate from the ratio using a predefined function.

20. The method of claim 19, wherein the predefined function includes a hyperbolic tangent function.

21. The method of claim 14, wherein the first charge section is a section where charging is performed in a constant current (CC) charge mode and the second charge section is a section where charging is performed in a constant voltage (CV) charge mode.

22. The method of claim 21, wherein the adjusting of the charge amount of the battery based on the state change rate includes:
increasing a charge current threshold value of the battery being charged in the second charge section based on the state change rate, thereby reducing the charge amount of the battery.

23. The method of claim 22, wherein the charge current threshold value includes a value that determines a charging termination time of the battery in the second charge section.

24. The method of claim 22, wherein the adjusting of the charge amount of the battery based on the state change rate further includes:
decreasing a charge voltage upper limit value of the battery in the next charge cycle based on the state change rate, thereby reducing the charge amount of the battery in the next charge cycle.

25. A battery charging system for controlling the charging of a battery, the battery charging system comprising:

a battery;
a charging device configured to charge the battery by applying a charging current to the battery; and
a battery charging control apparatus configured to control a magnitude of the charging current provided by the charging device,
wherein the battery charging control apparatus monitors charge state of the battery undergoing charging and adjusts a charge amount of the battery undergoing charging by comparing a change in the charge state of the battery during a process of charging with a reference charge state change which is derived from an initial state battery and pre-stored.

26. A computer-readable medium recording a program which, when executed by a computer, cause the computer to carry out any one of the methods of claims 13 to 24.

[Figure 1]

[Figure 2]

[Figure 3]

[Figure 4]

```
                    ┌──────────────┐
                    │    Start     │
                    └──────────────┘
                           │
                           ▼
        ┌─────────────────────────────────────┐
        │  monitor charge state of battery    │  ∽S410
        │  undergoing charging                │
        └─────────────────────────────────────┘
                           │
                           ▼
        ┌─────────────────────────────────────┐
        │  adjust charge amount of battery    │  ∽S420
        │  undergoing charging                │
        └─────────────────────────────────────┘
                           │
                           ▼
                    ┌──────────────┐
                    │     End      │
                    └──────────────┘
```

[Figure 5]

```
                    ┌──────────────┐
                    │    Start     │
                    └──────────────┘
                           │
                           ▼
        ┌─────────────────────────────────────┐
        │  initiate rapid charging of battery │  ∽S510
        └─────────────────────────────────────┘
                           │
                           ▼
        ┌─────────────────────────────────────┐
        │  obtain charge state information    │  ∽S520
        │  of battery                         │
        └─────────────────────────────────────┘
                           │
                           ▼
        ┌─────────────────────────────────────┐
        │  obtain charge state graph of       │  ∽S530
        │  battery                            │
        └─────────────────────────────────────┘
                           │
                           ▼
                    ┌──────────────┐
                    │     End      │
                    └──────────────┘
```

[Figure 6]

[Figure 7]

[Figure 8]

```
                    ┌──────────────┐
                    │    Start     │
                    └──────┬───────┘
                           │
                           ▼
┌───────────────────────────────────────────────────┐
│  calculate state change rate of battery by         │
│  comparing charge state graph with reference       │──S810
│  charge state graph                                │
└───────────────────────┬───────────────────────────┘
                        │
                        ▼
┌───────────────────────────────────────────────────┐
│  adjust charge amount of battery undergoing        │──S820
└───────────────────────┬───────────────────────────┘
                        │
                        ▼
                ┌──────────────┐
                │     End      │
                └──────────────┘
```

[Figure 9]

[Figure 10]

[Figure 11]

## INTERNATIONAL SEARCH REPORT

| International application No. |
|---|
| **PCT/KR2025/010433** |

**A. CLASSIFICATION OF SUBJECT MATTER**

**H02J 7/00**(2006.01)i; **G01R 31/3835**(2019.01)i; **G01R 31/392**(2019.01)i; **G01R 31/396**(2019.01)i

According to International Patent Classification (IPC) or to both national classification and IPC

**B. FIELDS SEARCHED**

Minimum documentation searched (classification system followed by classification symbols)

H02J 7/00(2006.01); G01R 19/165(2006.01); G01R 31/389(2019.01); G01R 31/392(2019.01); H01M 10/48(2006.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (MOIP internal) & keywords: 배터리(battery), 충전 상태(state of charge), 초기 상태(initial state), 비교 (comparison), 충전량(charging amount), 그래프(graph)

**C. DOCUMENTS CONSIDERED TO BE RELEVANT**

| Category* | Citation of document, with indication, where appropriate, of the relevant passages | Relevant to claim No. |
|---|---|---|
| Y | KR 10-2024-0070995 A (LG ENERGY SOLUTION, LTD.) 22 May 2024 (2024-05-22) claims 1, 15; and figures 2-3 | 1,13,25-26 |
| A | | 2-12,14-24 |
| Y | KR 10-2021-0028476 A (SAMSUNG ELECTRONICS CO., LTD. et al.) 12 March 2021 (2021-03-12) claims 19-20; and figures 1-4, 8 | 1,13,25-26 |
| A | KR 10-2021-0079085 A (LG ENERGY SOLUTION, LTD.) 29 June 2021 (2021-06-29) paragraphs [0014]-[0122]; claims 1-16; and figures 1-21 | 1-26 |
| A | US 2017-0070061 A1 (TEXAS INSTRUMENTS INCORPORATED) 09 March 2017 (2017-03-09) paragraphs [0043]-[0088]; claims 1-25; and figures 4-8 | 1-26 |
| A | JP 2018-147827 A (TOSHIBA CORPORATION) 20 September 2018 (2018-09-20) paragraphs [0010]-[0177]; claims 1-21; and figures 1-19 | 1-26 |

☐ Further documents are listed in the continuation of Box C.  ☑ See patent family annex.

| | | |
|---|---|---|
| * | Special categories of cited documents: | "T" later document published after the international filing date or priority date and not in conflict with the application but cited to understand the principle or theory underlying the invention |
| "A" | document defining the general state of the art which is not considered to be of particular relevance | |
| "D" | document cited by the applicant in the international application | "X" document of particular relevance; the claimed invention cannot be considered novel or cannot be considered to involve an inventive step when the document is taken alone |
| "E" | earlier application or patent but published on or after the international filing date | |
| "L" | document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" | document referring to an oral disclosure, use, exhibition or other means | |
| "P" | document published prior to the international filing date but later than the priority date claimed | "&" document member of the same patent family |

| Date of the actual completion of the international search | Date of mailing of the international search report |
|---|---|
| **30 October 2025** | **31 October 2025** |

| Name and mailing address of the ISA/KR | Authorized officer |
|---|---|
| **Korean Intellectual Property Office Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

EP 4 769 883 A1

**INTERNATIONAL SEARCH REPORT**
Information on patent family members

International application No.

**PCT/KR2025/010433**

| Patent document cited in search report | | | Publication date (day/month/year) | Patent family member(s) | | | Publication date (day/month/year) |
|---|---|---|---|---|---|---|---|
| KR | 10-2024-0070995 | A | 22 May 2024 | CN | 119256465 | A | 03 January 2025 |
| | | | | EP | 4518089 | A1 | 05 March 2025 |
| | | | | JP | 2025-515699 | A | 20 May 2025 |
| | | | | WO | 2024-106668 | A1 | 23 May 2024 |
| KR | 10-2021-0028476 | A | 12 March 2021 | CN | 112448055 | A | 05 March 2021 |
| | | | | CN | 112448055 | B | 13 June 2025 |
| | | | | EP | 3790153 | A1 | 10 March 2021 |
| | | | | JP | 2021-040476 | A | 11 March 2021 |
| | | | | JP | 7616841 | B2 | 17 January 2025 |
| | | | | KR | 10-2871577 | B1 | 17 October 2025 |
| | | | | US | 12081058 | B2 | 03 September 2024 |
| | | | | US | 2021-0066945 | A1 | 04 March 2021 |
| KR | 10-2021-0079085 | A | 29 June 2021 | CN | 114514435 | A | 17 May 2022 |
| | | | | EP | 4033631 | A1 | 27 July 2022 |
| | | | | EP | 4033631 | A4 | 14 December 2022 |
| | | | | EP | 4033631 | B1 | 19 February 2025 |
| | | | | EP | 4513212 | A2 | 26 February 2025 |
| | | | | EP | 4513212 | A3 | 21 May 2025 |
| | | | | ES | 3019282 | T3 | 20 May 2025 |
| | | | | HU | E070464 | T2 | 28 June 2025 |
| | | | | JP | 2022-550943 | A | 06 December 2022 |
| | | | | JP | 7376002 | B2 | 08 November 2023 |
| | | | | KR | 10-2874965 | B1 | 22 October 2025 |
| | | | | PL | 4033631 | T3 | 28 April 2025 |
| | | | | US | 12413090 | B2 | 09 September 2025 |
| | | | | US | 2023-0022874 | A1 | 26 January 2023 |
| | | | | WO | 2021-125475 | A1 | 24 June 2021 |
| US | 2017-0070061 | A1 | 09 March 2017 | CN | 107852011 | A | 27 March 2018 |
| | | | | CN | 114142563 | A | 04 March 2022 |
| | | | | US | 10044213 | B2 | 07 August 2018 |
| | | | | US | 10566819 | B2 | 18 February 2020 |
| | | | | US | 10892631 | B2 | 12 January 2021 |
| | | | | US | 2019-0006871 | A1 | 03 January 2019 |
| | | | | US | 2020-0144833 | A1 | 07 May 2020 |
| | | | | WO | 2017-044796 | A1 | 16 March 2017 |
| JP | 2018-147827 | A | 20 September 2018 | CN | 108574317 | A | 25 September 2018 |
| | | | | CN | 108574317 | B | 11 January 2022 |
| | | | | EP | 3373020 | A1 | 12 September 2018 |
| | | | | JP | 6567582 | B2 | 28 August 2019 |
| | | | | US | 11462780 | B2 | 04 October 2022 |
| | | | | US | 2018-0261893 | A1 | 13 September 2018 |

Form PCT/ISA/210 (patent family annex) (July 2022)

23

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

• KR 1020240096201